# EUROPÄISCHE PATENTANMELDUNG

(11) **EP 2 698 321 A1**
(43) Veröffentlichungstag der Anmeldung: **19.02.2014**
(21) Anmeldenummer: 13175176.0
(22) Anmeldetag: 04.07.2013
(51) Int. Cl.: B65D 1/02

(54) **Vorformling zum Herstellen eines Behältnisses und Behältnis zum Aufnehmen eines Lebensmittels**

(30) Priorität: 16.08.2012 DE 102012107506
(71) Anmelder: INOTECH Kunststofftechnik GmbH, 92507 Nabburg (DE)
(72) Erfinder: Gleixner, Josef, 93047 Regensburg (DE)
(74) Vertreter: Hannke, Christian

(57) **Zusammenfassung**

Die Erfindung betrifft einen Vorformling (1A) zum Herstellen eines Behältnisses (1) zum Aufnehmen eines Produktes, insbesondere eines Lebensmittels, mit einem eine Kavität (5) aufweisenden expandierbaren Grundkörper (3; 103; 203; 303) aus einem Mehrkomponentenmaterial (4; 104; 204; 304) umfassend wenigstens zwei aneinander grenzende Materialbereiche (7, 8; 107, 108; 207, 208; 307, 308), bei welchem der expandierbare Grundkörper (3; 103; 203; 303) an einem ersten (12; 112; 212; 312) seiner Endbereiche (12; 112; 212; 312) einen Mündungsbereichsabschnitt (11; 111; 211; 311) und an einem zweiten seiner Endbereiche (12; 112; 212; 312) einen diesen Mündungsbereichsabschnitt (11; 111; 211; 311) gegenüberliegenden Bodenbereichsabschnitt aufweist, wobei das Mehrkomponentenmaterial (4; 104; 204; 304) des expandierbaren Grundkörpers (3; 103; 203; 303) an dem Mündungsbereichsabschnitt (11; 111; 211; 311) ein Verstärkungselement (13; 113; 213; 313) zum partiellen Verstärken des Vorformlings (1 A) umfasst.

## Beschreibung

Die Erfindung betrifft nach einem ersten Aspekt einen Vorformling zum Herstellen eines Behältnisses zum Aufnehmen eines Produktes, insbesondere eines Lebensmittels, mit einem eine Kavität aufweisenden expandierbaren Grundkörper aus einem Mehrkomponentenmaterial umfassend wenigstens zwei aneinander grenzende Materialbereiche, bei welchem der expandierbare Grundkörper an einem ersten seiner Endbereiche einen Mündungsbereichsabschnitt und an einem zweiten seiner Endbereiche einen diesen Mündungsbereichsabschnitt gegenüberliegenden Bodenbereichsabschnitt aufweist.

Die Erfindung betrifft nach einem weiteren Aspekt ein Behältnis zum Aufnehmen eines Produktes, insbesondere eines Lebensmittels, mit einem eine Kavität aufweisenden expandierten Grundkörper aus einem Mehrkomponentenmaterial umfassend wenigstens zwei aneinander grenzende Materialbereiche, bei welchem der expandierte Grundkörper an einem ersten seiner Endbereiche einen Mündungsbereichsabschnitt und an einem zweiten seiner Endbereiche einen diesen Mündungsbereichsabschnitt gegenüberliegenden Bodenbereichsabschnitt aufweist.

Sowohl gattungsgemäße Vorformlinge als auch gattungsgemäße Behältnisse sind aus dem Stand der Technik hinreichend gut bekannt und werden insbesondere in der Getränkeindustrie seit Jahren erfolgreich eingesetzt, um Getränke beispielsweise in Kunststoffflaschen zu bevorraten.

Während die ersten derartiger Behältnisse noch eine denkbar einfache Gestalt und einen entsprechend einfachen Aufbau aufwiesen, stiegen im Laufe der Zeit die Anforderungen insbesondere an diese Behältnisse hinsichtlich Design, Handhabung und Herstellung, wodurch sich dementsprechend auch die Anforderungen an diesbezügliche Vorformlinge erhöhten, um entsprechende Behältnisse massenhaft zur Verfügung zu stellen. Speziell durch die Verwendung von expandierbaren Grundkörpern aus Mehrkomponentenmaterialien kann die Gestaltungsvielfalt hinsichtlich der herzustellenden Behältnisse vorteilhaft erhöht werden.

Es ist Aufgabe der vorliegenden Erfindung herkömmliche Vorformlinge und hieraus hergestellte Behältnisse derart weiterzuentwickeln, dass einerseits die Gebrauchseigenschaften von aus den Vorformlingen hergestellten weiterentwickelten Behältnissen wesentlich verbessert und andererseits diese weiterentwickelten Behältnisse andererseits extrem einfach und entsprechend kostengünstig herstellbar sind.

Die vorliegende Aufgabe wird nach einem ersten Aspekt der Erfindung von einem Vorformling zum Herstellen eines Behältnisses zum Aufnehmen eines Produktes, insbesondere eines Lebensmittels, mit einem eine Kavität aufweisenden expandierbaren Grundkörper aus einem Mehrkomponentenmaterial umfassend wenigstens zwei aneinander grenzende Materialbereiche gelöst, bei welchem der expandierbare Grundkörper an einem ersten seiner Endbereiche einen Mündungsbereichsabschnitt und an einem zweiten seiner Endbereiche einen diesen Mündungsbereichsabschnitt gegenüberliegenden Bodenbereichsabschnitt aufweist, wobei das Mehrkomponentenmaterial des expandierbaren Grundkörpers an dem Mündungsbereichsabschnitt ein Verstärkungselement zum partiellen Verstärken des Vorformlings umfasst.

Durch das erfindungsgemäße Vorsehen des Verstärkungselements an dem Mündungsbereichsabschnitt des Grundkörpers kann ein vorteilhaft gestaltetes Behältnis im Hinblick auf seinen Verschlussbereich auf außerordentlich einfache Weise und sehr kostengünstig hergestellt werden.

Zudem lässt sich der Vorformling wesentlich robuster an seinem Mündungsbereichsabschnitt greifen und verschiedenen Bearbeitungsstationen zuführen, da durch das Verstärkungselement die Gefahr einer kritischen Verformung oder Beschädigung am Mündungsbereichsabschnitt durch Greif- oder Bearbeitungseinrichtungen wesentlich reduzieren lässt. Dies ist besonders bei einem Blas- oder Blas-Streckprozess vorteilhaft, bei welchem der Vorformling zu dem Behältnis mittels einer Blas- oder Blas-Streckmaschine expandiert wird.

Nach einem weiteren Aspekt der Erfindung wird die vorliegende Aufgabe auch von einem Behältnis zum Aufnehmen eines Produktes, insbesondere eines Lebensmittels, mit einem eine Kavität aufweisenden expandierten Grundkörper aus einem Mehrkomponentenmaterial umfassend wenigstens zwei aneinander grenzende Materialbereiche gelöst, bei welchem der expandierte Grundkörper an einem ersten seiner Endbereiche einen Mündungsbereichsabschnitt und an einem zweiten seiner Endbereiche einen diesen Mündungsbereichsabschnitt gegenüberliegenden Bodenbereichsabschnitt aufweist, wobei das Mehrkomponentenmaterial des expandierten Grundkörpers an dem Mündungsbereichsabschnitt ein Verstärkungselement zum partiellen Verstärken des Vorformlings umfasst.

Vorteilhafter Weise gelingt es durch das Vorhandensein des erfindungsgemäßen Verstärkungselements, dass das Behältnis an seinem Verschlussbereich, also an dem Mündungsbereichsabschnitt, besonders stabil ausgestaltet ist.

Der Begriff "Mündungsbereichsabschnitt" bezeichnet den Abschnitt, an welchem die Kavität über eine Öffnung zugänglich ist. In der Regel befindet sich in diesem Mündungsbereichsabschnitt auch ein Außengewinde zum Aufschrauben eines Verschlussdeckels eines Behältnisses.

An diesen Mündungsbereichsabschnitt schließt sich ein Bauchbereichsabschnitt umfassend den Bodenbereichsabschnitt des Grundkörpers an. Insofern kann das Verstärkungselement auch von dem Mündungsbereichsabschnitt in den Bauchbereichsabschnitt erstrecken

Der Begriff "Verstärkungselement" beschriebt vorliegend einen Materialbereich des Grundkörpers, welcher den Grundkörper zumindest in diesem Areal durch ausgesuchte Materialeigenschaften gegenüber auf dem Grundkörper einwirkenden Kräfte, insbesondere Druckkräften, widerstandsfähiger macht. Besonders vorteilhaft kann ein solcher Materialbereich kumulativ oder alternativ auch gegenüber höheren Temperaturen resistenter sein als an andere Materialbereiche der Grundkörpers. Dies ist insbesondere beim eigentlichen Herstellungsprozess vom Vorformling zum Behältnis vorteilhaft, da sich hierdurch neue Verfahrensführungsmöglichkeiten ergeben können.

Im Allgemeinen besteht der Grundkörper aus einer Materialkomponente umfassend Polyethylenterephthalat, kurz PET. Beispielsweise PET-Getränkeflaschen sind weitläufig und nahezu jedem bekannt.

Vorliegend besteht der Grundkörper jedoch noch aus einer weiteren Materialkomponente, wobei die vorliegenden aneinander grenzenden Materialbereiche bezogen auf die Längsachse des Grundkörpers schichtartig radial nebeneinander liegend und/oder schichtartig axial nebeneinander liegend, sprich schichtartig übereinander liegend, angeordnet sein können.

Es ist vorteilhaft, wenn das Verstärkungselement an wenigstens einem der Materialbereiche angespritzt und/oder von wenigstens einem der Materialbereiche umspritzt angeordnet ist.

Das Verstärkungselement kann verfahrenstechnisch besonders einfach an dem Grundkörper realisiert werden, wenn es an diesem angespritzt ist.

Insbesondere kann das Verstärkungselement außen an dem Mündungsbereichsabschnitt des Grundkörpers konstruktiv einfach angespritzt werden, wodurch das Verstärkungselement den Grundkörper hinsichtlich seiner äußeren Mantelfläche zumindest teilweise begrenzen kann.

In diesem Zusammenhang ist es besonders vorteilhaft, wenn das Verstärkungselement ein Gewinde umfasst. Somit kann das Verstärkungselement neben reinen Formstabilitätsaufgaben vorteilhafter Weise sogleich noch weitere Funktionsaufgaben übernehmen. Insbesondere kann ein besonders stabiles und weniger stark verformbares Gewinde realisiert werden.

Aber auch innen an dem Mündungsbereichsabschnitt, kann das Verstärkungselement problemlos realisiert werden, wenn es von wenigstens einem der Materialbereiche umspritzt wird. Somit kann das Verstärkungselement vorteilhafter Weise sogleich die Kavität zumindest teilweise begrenzen.

Ist das Verstärkungselement durch wenigstens einen der aneinander angrenzenden Materialbereiche des Mehrkomponentenmaterials ausgestaltet, kann es an dem Grundkörper konstruktiv außerordentlich einfach bereitgestellt werden.

Umfasst das Verstärkungselement einen thermoplastischen Werkstoff, kann es insbesondere hinsichtlich der bei einem Blasverfahren üblichen Temperaturen auch vorteilhaft besonders formstabil bleiben. Somit weist das Verstärkungselement diesbezüglich eine höhere Formstabilität auf, als bisher üblich.

Es versteht sich, dass das vorliegende Verstärkungselement durch unterschiedlichste Werkstoffe vorteilhaft realisiert werden kann, wie beispielsweise Polypropylen (PP) oder insbesondere High-Density-Polyethylen (HDPE) oder dergleichen.

Als besonders vorteilhaft hat es sich erwiesen, wenn das Verstärkungselement Polyethylenterephthalat-Copolyester (PETG) oder Polycarbonat (PC) umfasst. Insbesondere können durch ein derartiges Verstärkungselement differenziertere thermische Eigenschaften an dem Grundköper zumindest bereichsweise erzielt werden.

Eine bereits sehr gute Anbindung des Verstärkungselements gegenüber angrenzende Materialbereiche des Mehrkomponentenmaterials kann erreicht werden, wenn das Verstärkungselement ein Ringelement umfasst, welches an seiner Ringelementeinnenseite oder an seiner Ringelementeaußenseite an einer weiteren Materialkomponenten des Grundkörpers angrenzt.

Gestaltet das Verstärkungselement die Stirnseite des Mündungsbereichsabschnitts aus, kann vorteilhafter Weise direkt der komplette außenliegende Mündungsbereichsabschnitt des Grundkörpers von dem Verstärkungselement formuliert werden.

Weist das Verstärkungselement zusätzlich ein nach radial innen kragendes, konzentrisch umlaufendes Stegteil auf, kann der Mündungsbereichsabschnitt nicht nur radial außen sondern auch axial außen von dem Verstärkungselement ausgestaltet sind. Radial und axial beziehen sich hierbei auf die Mittellängsachse des Vorformlings bzw. des Behältnisses.

Zudem ist es vorteilhaft, wenn das Verstärkungselement konzentrisch um die Mittellängsachse des Vorformlings oder des Behältnisses und/oder konzentrisch um den Mündungsbereichsabschnitt herum angeordnet ist. Hierdurch kann eine sehr gleichmäßige Verteilung des Verstärkungselements am Umfang des Grundkörpers erzielt werden, so dass sich die Vorstabilität des Grundkörpers zumindest partiell verbessert.

Ein Grenzflächenkontakt zwischen einer Materialkomponente des Verstärkungselements und einer weiteren Materialkomponente des Grundkörpers kann weiter wesentlich erhöht werden, wenn das Verstärkungselement ein Ringelement mit einem konisch ausgestalteten Kragenteil umfasst. Hierdurch kann sich das Verstärkungselement vorteilhafter Weise konstruktiv außerordentlich einfach noch weiter bis in andere Bereiche des Grundkörpers erstrecken.

Insofern ist das Verstärkungselement dann von dem Mündungsbereichsabschnitt bis in den Bauchbereichsabschnitt hinein erstreckend angeordnet, wodurch vorteilhafter Weise ein gesamter Nackenbereichsabschnitt des Grundkörpers verstärkt ist.

Erstreckt sich das Verstärkungselement vorteilhafter Weise also über den gesamten Nackenbereichsabschnitt des Grundkörpers, können selbst größere Flächenbereiche des Vorformlings und insbesondere des fertig geblasenen Behältnisses formstabiler ausgestaltet werden.

Ist das Verstärkungselement von drei Seiten mit einer der Materialkomponenten des Grundkörpers umschlossen, kann es besonders innig in den Grundkörper integriert werden, und dennoch zusätzliche Funktionsbereiche an dem Grundkörper ausgestalten, wie beispielsweise ein Außengewinde.

Im Übrigen sei an dieser Stelle noch darauf hingewiesen, dass ein gattungsgemäßes Verstärkungselement kumulativ oder alternativ auch an dem Bodenbereichsabschnitt des Grundkörpers vorteilhaft vorgesehen werden kann.

Beispielsweise ist das in dem Bodenbereichsabschnitt vorgesehene Verstärkungselement zumindest teilweise im Wesentlichen sternförmig in einer der Materialkomponenten des Mehrkomponentenmaterials des Grundkörpers ausgestaltet.

Vorteilhafter Weise kann das Verstärkungselement zumindest bereichsweise auch die äußere Mantelfläche des Bodenbereichsabschnitts ausgestalten.

Dies ist besonders dann vorteilhaft, wenn der Bodenbereichsabschnitt gegenüber einem Untergrund besonders rutschsicher ausgestaltet werden soll.

Besonders gute Antirutscheigenschaften können am Bodenbereichsabschnitt erzielt werden, wenn dort das Verstärkungselement Polyurethane (PUR) oder thermoplastische Elastomere (TPE) umfasst.

Eine besonders hohe Stabilisierung des Bodenbereichsabschnitts kann erreicht werden, wenn das Verstärkungselement in dem Bodenbereichsabschnitt aus einem Glykol umfassenden Polyethylenterephthalat (PET-G) herstellt ist.

Weitere Vorteile, Ziele und Eigenschaften vorliegender Erfindung werden anhand anliegender Zeichnung und nachfolgender Beschreibung erläutert, in welchen beispielhaft ein erstes Behältnis mit einem aus einem Mehrkomponentenmaterial hergestellten Grundkörper mit einem ein Verstärkungselement umfassenden Mündungsbereichsabschnitt, sowie alternativ weitere unterschiedlich ausgestaltete Mündungsbereichsabschnitte mit Verstärkungselementen dargestellt und beschrieben sind. In der Zeichnung zeigen:
- Figur 1: schematisch eine Ansicht eines längsgeschnittenen aus einem Vorformling expandierten Behältnisses mit einem in seinem Mündungsbereichsabschnitt angeformten ringförmigen und einen trichterförmigen Kragen aufweisenden Verstärkungselement;
- Figur 2: schematisch eine Detailansicht eines längsgeschnittenen Mündungsbereichsabschnitts eines weiteren aus einem Vorformling expandierten Behältnisses mit einem außen am Mündungsbereichsabschnitt angeformten ringförmigen Verstärkungselement mit einem nach innen kragenden und konzentrisch umlaufenden Stegteil;
- Figur 3: schematisch eine Detailansicht eines längsgeschnittenen Mündungsbereichsabschnitts eines anderen aus einem Vorformling expandierten Behältnisses mit einem außen am Mündungsbereichsabschnitt angeordneten und von drei Seiten umspritzten ringförmigen Verstärkungselement; und
- Figur 4: schematisch eine Detailansicht eines längsgeschnittenen Mündungsbereichsabschnitts eines alternativen aus einem Vorformling expandierten Behältnisses mit einem innen am Mündungsbereichsabschnitt angeformten ringförmigen Verstärkungselement.

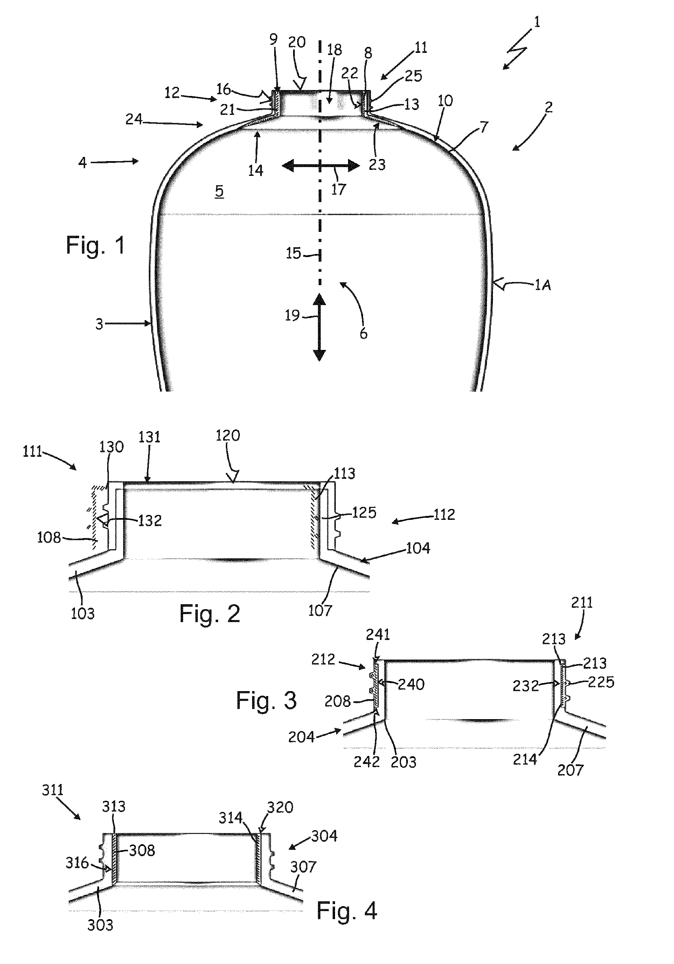

Das in der Figur 1 gezeigte Behältnis 1 ist eine Getränkekunststoffflasche 2, welche mit Hilfe eines Streck-Blasverfahrens aus einem Vorformling 1 A (bereits expandiert dargestellt) aus einem Grundkörper 3 aus einem Mehrkomponentenmaterial 4 hergestellt ist.

Der Grundkörper 3 ist bis auf seine Gestalt hinsichtlich des Behältnisses 1 und des Vorformlings 1 A derselbe, und er gestaltet eine Kavität 5 aus, welche hinsichtlich des Behältnisses 1 in einem Bauchbereichsabschnitt 6 verständlicher Weise ein wesentliches größeres Volumen aufweist als hinsichtlich des noch nicht expandierten Vorformlings 1 A.

Das Mehrkomponentenmaterial 4, aus welchem der Grundkörper 3 besteht, weist einen ersten Materialbereich 7 aus Polyethylenterephthalat (PET) und einen zweiten Materialbereich 8 aus Polycarbonat (PC) auf, die beide als eine ersten Schicht 9 und eine zweite Schicht 10 schichtartig aneinander grenzend angeformt sind.

Der zweite Materialbereich 8 ist in diesem Ausführungsbeispiel in einem Mündungsbereichsabschnitt 11 an einem ersten Endbereich 12 des Grundkörpers 3 angeordnet, welcher einem zweiten hier nicht gezeigten Endbereich des Grundkörpers 3 gegenüberliegt. In diesem zweiten Endbereich ist ein Bodenbereichsabschnitt (hier nicht gezeigt) des Grundkörpers 3 ausgestaltet, mittels welchem das Behältnis 1 sicher auf einem Untergrund (hier nicht gezeigt) abgestellt werden kann.

Der zweite Materialbereich 8 gestaltet erfindungsgemäß ein Verstärkungselement 13 in dem Mündungsbereichsabschnitt 11 aus, welches als Ringelement 14 konzentrisch um die Mittellängsachse 15 des Grundkörpers 3 angeordnet ist.

In diesem Ausführungsbeispiel ist das Ringelement 14 an seiner Ringelementeaußenseite 16 radial 17 außen vollständig von der ersten Materialkomponente 7 umgeben ist.

Das Verstärkungselement 13 begrenzt somit einerseits die einzige Öffnung 18 des Grundkörpers 3, durch welche hindurch die Kavität 5 zugänglich ist.

Andererseits begrenzt das Verstärkungselement 13 bzw. der diesbezügliche zweite Materialbereich 8 gemeinsam mit dem ersten Materialbereich 7 axial 19 eine Stirnseite 20 des Mündungsbereichsabschnitts 11.

Um die Grenzfläche 21, welche als Kontaktfläche zwischen den beiden aneinander grenzenden Materialbereichen 7 und 8 vorliegt, vorteilhaft zu vergrößern, weist das Verstärkungselement 13 neben einem zylindrischen Teil 22 noch einen konisch ausgestalteten bzw. trichterförmigen Kragenteil 23 auf.

Der konische Kragenteil 23 ist an einer der Stirnseite 20 abgewandten Seite 24 des Verstärkungselements 13 vorgesehen, und er erstreckt sich ausgehend von dem zylindrischen Teil 22 des Verstärkungselements 13 weiter bis in den Bauchbereichsabschnitt 6 hinein.

Während der zylindrische Teil 22 im Wesentlichen eine gleichbleibende Wandstärke aufweist, zeichnet sich der konische Kragenteil 23 durch eine veränderliche Wandstärke aus, da der konische Kragenteil 23 während der Umformung des Grundkörpers 3 von dem Vorformling 1 A zu dem Behältnis 1 zumindest teilweise gestreckt und der konische Kragenteil 23 hierdurch gelängt wurde.

Die erste Materialkomponente 7 formt im Mündungsbereichsabschnitt 11 noch ein Außengewinde 25 an dem Grundkörper 3 aus, auf welches ein Verschlussdeckel (hier nicht gezeigt) aufgeschraubt werden kann, so dass die Kavität 5 verschlossen ist.

Weitere Beispiele zu möglichen vorteilhaften Ausführungsvarianten hinsichtlich Vorformlinge 1 A und hieraus hergestellten Behältnissen 1 sind in den Darstellungen der Figuren 2, 3 und 4 gezeigt. Um Wiederholungen zu vermeiden, werden hinsichtlich dieser Ausführungsvarianten nachfolgend nur die wesentlichen Unterschiede beschrieben und ergänzend auf das vorstehend erläuterte und in der Figur 1 gezeigte Ausführungsbeispiel verwiesen.

Bei einem in der Figur 2 gezeigten alternativen Mündungsbereichsabschnitt 111 ist ein Verstärkungselement 113 zum partiellen Verstärken eines Grundkörpers 103 eines weiteren vorteilhaften Vorformlings 1 A bzw. Behältnisses 1 sowohl axial als auch radial außen an einem ersten Materialbereich 107 eines Mehrkomponentenmaterials 104 des Grundkörpers 103 angeformt, wobei das Verstärkungselement 113 ein nach radial 17 innen kragendes, konzentrisch umlaufendes Stegteil 130 aufweist, welches als eine Art offenes Kappenelement 131 des Mündungsbereichsabschnitts 111 außen vollständig abdeckt. Das Verstärkungselement 113 befindet sich an einem ersten Endbereich 112 des Grundkörpers 103.

Das Verstärkungselement 113 ist durch einen zweiten Materialbereich 108 des Mehrkomponentenmaterials 104 ausgestaltet, und es ist an dem ersten Materialbereich 107 umspritzt angeordnet.

Insofern gestaltet allein das Verstärkungselement 113 eine Stirnseite 120 des Mündungsbereichsabschnitts 111 vollständig aus.

Auch definiert das Verstärkungselement 113 ein Außengewinde 125 zum Aufschrauben eines auch hier nicht gezeigten Verschlussdeckels.

Der erste Materialbereich 107 ist an einer Ringelementeinnenseite 132 eines durch das Verstärkungselement 113 ausgebildeten Ringelements 114 angeformt.

Bei dem in der Figur 3 gezeigten weiteren Mündungsbereichsabschnitt 211 eines weiteren vorteilhaften Vorformlings 1A bzw. Behältnisses 1 ist ein Verstärkungselement 213 zum partiellen Verstärken eines Grundkörpers 203 radial außen an einem ersten Materialbereich 207 des Grundkörpers 203 aus einem Mehrkomponentenmaterial 204 angeformt, wobei das Verstärkungselement 213 von drei Grenzflächenseiten 240, 241 und 242 des ersten Materialbereichs 207 umschlossen und somit besonders gut in den Grundkörper 203 integriert ist.

Die erste Grenzflächenseite 240 ist hierbei identisch mit einer Ringelementeinnenseite 232 eines durch das Verstärkungselement 213 ausgestalteten Ringelements 214, welches an seiner Ringelementeinnenseite 232 an dem ersten Materialbereich 207 angrenzt.

Das Verstärkungselement 213 ist durch einen zweiten Materialbereich 208 des Mehrkomponentenmaterials 204 ausgestaltet, und es ist in einem ersten Endbereich 212 des Grundkörpers 203 an dem ersten Materialbereich 207 zumindest teilweise umspritzt angeordnet. Das Verstärkungselement 313 formt hierbei noch ein Außengewinde 325 zum Aufschrauben eines auch hier wieder nicht gezeigten Verschlussdeckels aus.

Bei dem letztlich in der Figur 4 gezeigten anderen Mündungsbereichsabschnitt 311 eines weiteren vorteilhaften Vorformlings 1A bzw. Behältnisses 1 sitzt ein einfach ringförmig ausgestaltetes Verstärkungselement 313 zum partiellen Verstärken eines Grundkörpers 303 wieder innen an dem Mündungsbereichsabschnitt 311 in einem ersten Endbereich 312 des Grundkörpers 303. Das Verstärkungselement 313 ist als Ringelement 314 mit seiner Ringelementeaußenseite 316 an einer ersten Materialkomponente 307 angeformt.

Das Verstärkungselement 313 ist durch einen zweiten Materialbereich 308 des Mehrkomponentenmaterials 304 ausgestaltet, und es zeichnet sich durch eine geometrisch einfache zylindrische Gestalt aus, so dass es spritztechnisch dementsprechend besonders einfach bereitgestellt werden kann.

Darüber hinaus gestaltet das Verstärkungselement 313 bzw. dessen zweiter Materialbereich 308 gemeinsam mit dem ersten Materialbereich 307 eine Stirnseite 320 des Mündungsbereichsabschnitts 311 aus.

Auch alle weiteren gezeigten und beschriebenen Verstärkungselemente 113, 213 und 313 sind konzentrisch um den jeweiligen Mündungsbereichsabschnitt 111, 211 bzw. 311 hierum angeordnet.

Es versteht sich, dass es sich bei den vorstehend erläuterten Ausführungsbeispielen lediglich um erste Ausgestaltungen des erfindungsgemäßen Vorformlings zum Herstellen eines Behältnisses bzw. eines hieraus hergestellten erfindungsgemäßen Behältnisses zum Aufnehmen eines Lebensmittels handelt. Insofern beschränkt sich die Ausgestaltung der Erfindung nicht auf diese Ausführungsbeispiele.

Sämtliche in den Anmeldungsunterlagen offenbarten Merkmale werden als erfindungswesentlich beansprucht, sofern sie einzeln oder in Kombination gegenüber dem Stand der Technik neu sind.

### Bezugszeichenliste

- 1: Behältnis
- 1A: Vorformling
- 2: Getränkekunststoffflasche
- 3: Grundkörper
- 4: Mehrkomponentenmaterial
- 5: Kavität
- 6: Bauchbereichsabschnitt
- 7: erster Materialbereich
- 8: zweiter Materialbereich
- 9: erste Schicht
- 10: zweite Schicht
- 11: Mündungsbereichsabschnitt
- 12: erster Endbereich
- 13: Verstärkungselement
- 14: Ringelement
- 15: Mittellängsachse
- 16: Ringelementeaußenseite
- 17: radial
- 18: Öffnung
- 19: axial
- 20: Stirnseite
- 21: Grenzfläche
- 22: zylindrischer Teil
- 23: konischer Kragenteil
- 24: abgewandte Seite
- 25: Außengewinde

- 103: Grundkörper
- 104: Mehrkomponentenmaterial
- 107: erster Materialbereich
- 108: zweiter Materialbereich
- 111: Mündungsbereichsabschnitt
- 112: erster Endbereich
- 113: Verstärkungselement
- 114: Ringelement
- 120: Stirnseite
- 125: Außengewinde
- 130: Stegteil
- 131: Kappenelement
- 132: Ringelementeinnenseite
- 203: Grundkörper
- 204: Mehrkomponentenmaterial
- 207: erster Materialbereich
- 208: zweiter Materialbereich
- 211: Mündungsbereichsabschnitt
- 212: erster Endbereich
- 213: Verstärkungselement
- 214: Ringelement
- 225: Außengewinde
- 232: Ringelementeinnenseite
- 240: erste Grenzflächenseite
- 241: zweite Grenzflächenseite
- 242: dritte Grenzflächenseite

- 303: Grundkörper
- 304: Mehrkomponentenmaterial
- 307: erster Materialbereich
- 308: zweiter Materialbereich
- 311: Mündungsbereichsabschnitt
- 313: Verstärkungselement
- 314: Ringelement
- 316: Ringelementeaußenseite
- 320: Stirnseite

## Patentansprüche

1. Vorformling (1A) zum Herstellen eines Behältnisses (1) zum Aufnehmen eines Produktes, insbesondere eines Lebensmittels, mit einem eine Kavität (5) aufweisenden expandierbaren Grundkörper (3; 103; 203; 303) aus einem Mehrkomponentenmaterial (4; 104; 204; 304) umfassend wenigstens zwei aneinander grenzende Materialbereiche (7, 8; 107, 108; 207, 208; 307, 308), bei welchem der expandierbare Grundkörper (3; 103; 203; 303) an einem ersten (12; 112; 212; 312) seiner Endbereiche (12; 112; 212; 312) einen Mündungsbereichsabschnitt (11; 111; 211; 311) und an einem zweiten seiner Endbereiche (12; 112; 212; 312) einen diesen Mündungsbereichsabschnitt (11; 111; 211; 311) gegenüberliegenden Bodenbereichsabschnitt aufweist, **dadurch gekennzeichnet, dass** das Mehrkomponentenmaterial (4; 104; 204; 304) des expandierbaren Grundkörpers (3; 103; 203; 303) an dem Mündungsbereichsabschnitt (11; 111; 211; 311) ein Verstärkungselement (13; 113; 213; 313) zum partiellen Verstärken des Vorformlings (1 A) umfasst.

2. Behältnis (1) zum Aufnehmen eines Produktes, insbesondere eines Lebensmittels, mit einem eine Kavität (5) aufweisenden expandierten Grundkörper (3; 103; 203; 303) aus einem Mehrkomponentenmaterial (4; 104; 204; 304) umfassend wenigstens zwei aneinander grenzende Materialbereiche (7, 8; 107, 108; 207, 208; 307, 308), bei welchem der expandierte Grundkörper an (3; 103; 203; 303) einem ersten (12; 112; 212; 312) seiner Endbereiche (12; 112; 212; 312) einen Mündungsbereichsabschnitt (11; 111; 211; 311) und an einem zweiten seiner Endbereiche (12; 112; 212; 312) einen diesen Mündungsbereichsabschnitt (11; 111; 211; 311) gegenüberliegenden Bodenbereichsabschnitt aufweist, **dadurch gekennzeichnet, dass** das Mehrkomponentenmaterial (4; 104; 204; 304) des expandierten Grundkörpers (3; 103; 203; 303) an dem Mündungsbereichsabschnitt (11; 111; 211; 311) ein Verstärkungselement (13; 113; 213; 313) zum partiellen Verstärken des Behältnisses (1) umfasst.

3. Vorformling (1A) oder Behältnis (1) nach Anspruch 1 oder 2,
**dadurch gekennzeichnet, dass**
das Verstärkungselement (13; 113; 213; 313) an wenigstens einem (7; 107; 207; 307) der Materialbereiche (7, 8; 107, 108; 207, 208; 307, 308) angespritzt und/oder von wenigstens einem (7; 107; 207; 307) der Materialbereiche (7, 8; 107, 108; 207, 208; 307, 308) umspritzt angeordnet ist.

4. Vorformling (1A) oder Behältnis (1) nach einem der Ansprüche 1 bis 3, **dadurch gekennzeichnet, dass** das Verstärkungselement (13; 113; 213; 313) durch wenigstens einen (8; 108; 208; 308) der aneinander angrenzenden Materialbereiche (7, 8; 107, 108; 207, 208; 307, 308) des Mehrkomponentenmaterials (4; 104; 204; 304) ausgestaltet ist.

5. Vorformling (1 A) oder Behältnis (1) nach einem der Ansprüche 1 bis 4,
**dadurch gekennzeichnet, dass**
das Verstärkungselement (13; 113; 213; 313) einen thermoplastischen Werkstoff umfasst.

6. Vorformling (1A) oder Behältnis (1) nach einem der Ansprüche 1 bis 5,
**dadurch gekennzeichnet, dass**
das Verstärkungselement (13; 113; 213; 313) Polyethylenterephthalat-Copolyester (PETG) oder Polycarbonat (PC) umfasst.

7. Vorformling (1A) oder Behältnis (1) nach einem der Ansprüche 1 bis 6,
**dadurch gekennzeichnet, dass**
das Verstärkungselement (13; 113; 213; 313) konzentrisch um die Mittellängsachse (15) des Vorformlings (1 A) oder des Behältnisses (1) und/oder konzentrisch um den Mündungsbereichsabschnitt (11; 111; 211; 311) herum angeordnet ist.

8. Vorformling (1 A) oder Behältnis (1) nach einem der Ansprüche 1 bis 7,
**dadurch gekennzeichnet, dass**
das Verstärkungselement (13; 113; 313) die Stirnseite (20; 120; 320) des Mündungsbereichsabschnitts (11; 111; 311) ausgestaltet, und insbesondere einen nach radial (17) innen kragenden, konzentrisch umlaufenden Stegteil (130) aufweist.

9. Vorformling (1A) oder Behältnis (1) nach einem der Ansprüche 1 bis 8,
**dadurch gekennzeichnet, dass**
das Verstärkungselement (13; 113; 213; 313) ein Ringelement (14; 114; 214; 314) umfasst, welches an seiner Ringelementeinnenseite (132; 232) oder an seiner Ringelementeaußenseite (16; 316) an einer Materialkomponenten des Grundkörpers (3; 103; 203; 303) angrenzt.

10. Vorformling (1 A) oder Behältnis (1) nach einem der Ansprüche 1 bis 9,
**dadurch gekennzeichnet, dass**
das Verstärkungselement (13) ein Ringelement (14) mit einem konisch ausgestalteten Kragenteil (23) umfasst.

11. Vorformling (1 A) oder Behältnis (1) nach einem der Ansprüche 1 bis 10,
**dadurch gekennzeichnet, dass**
das Verstärkungselement (113; 213) ein Gewinde (125; 225) umfasst.

12. Vorformling (1A) oder Behältnis (1) nach einem der Ansprüche 1 bis 11,
**dadurch gekennzeichnet, dass**
das Verstärkungselement (213) von drei Seiten (240, 241, 242) mit einer der Materialkomponenten des Grundkörpers (203) umschlossen ist.
